(19) Europäisches Patentamt

European Patent Office

Office européen des brevets

(11) EP 0 595 018 B1

(12) EUROPÄISCHE PATENTSCHRIFT

(45) Veröffentlichungstag und Bekanntmachung des Hinweises auf die Patenterteilung:
**12.01.2000 Patentblatt 2000/02**

(51) Int Cl.⁷: H03F 1/52

(21) Anmeldenummer: 93115145.0

(22) Anmeldetag: 21.09.1993

(54) **Monolithisch integriertes MOS-Endstufenbauteil mit einer Übertemperatur-Schutzeinrichtung**

Monolithically integrated final MOS-transistor stage with an overheating preventing circuit

Etage final intégré pour des amplificateurs de puissance à transistor MOS comprenant un circuit de prévention de surchauffe

(84) Benannte Vertragsstaaten:
**DE ES FR GB IT**

(30) Priorität: **28.10.1992 DE 4236333**

(43) Veröffentlichungstag der Anmeldung:
**04.05.1994 Patentblatt 1994/18**

(73) Patentinhaber: **ROBERT BOSCH GMBH
70442 Stuttgart (DE)**

(72) Erfinder:
• **Uebele, Manfred, Dipl.-Ing.
D-72760 Reutlingen (DE)**

• **Brauchle, Peter, Dipl.-Phys.
D-72147 Nehren (DE)**

(56) Entgegenhaltungen:
EP-A- 0 090 280     EP-A- 0 224 274
DE-A- 2 106 312     US-A- 3 906 310
US-A- 4 896 245

• **H-M REIN, R RANFFT 'Halbleiter-Elektronik 13,Integrierte Bipolarschaltungen', 1980, SPRINGER VERLAG, BERLIN * Seite 64 - Seite 65 ***

**Beschreibung**

STAND DER TECHNIK

Die Erfindung betrifft ein monolithisch integriertes MOS-Endstufenbauteil, insbesondere eine DMOS-Endstufe, mit einem einen GATE-, einen SOURCE- und einen DRAIN-Anschluß aufweisenden Endstufenelement sowie mit einer Übertemperatur-Schutzeinrichtung, wie dies im Oberbegriff des Anspruchs 1 definiert ist.

Aus dem Dokument EP-A-0 224 274 ist ein derartiges Endstufenbauteil bekannt. Aus der IC-Entwicklung sind mehrere Lösungen für Übertemperatur-Schutzeinrichtungen bekannt, die die Flußspannung von bipolaren Dioden bzw. Transistoren nutzen. Bei diesen bekannten Schutzeinrichtungen treten häufig störende Wannenleckströme auf und/oder diese Schutzeinrichtungen können nicht in allen Betriebszuständen arbeiten, so daß zusätzliche elektronische Maßnahmen erforderlich sind, die die Integration aufwendig und teuer machen.

VORTEILE DER ERFINDUNG

Gemäß der Erfindung wird dieser Nachteil durch die Merkmale des Kennzeichens beheben.

Die temperaturempfindliche Z-Diode in der erfindungsgemäßen Anordnung weist eine sehr hohe Empfindlichkeit auf. Ihr Sperrstrom verdoppelt sich beispielsweise pro 10 K Temperaturerhöhung. Dieser Sperrstrom ruft am temperaturabhängigen Widerstand mit positivem Temperaturkoeffizienten einen Spannungsabfall hervor, der von einer Auswerteschaltung mit einer Referenzspannung verglichen wird. Damit ergibt sich eine hohe Gesamtsteilheit für das Auswertesignal und eine geringe Temperaturunschärfe bei prozeßbedingter Streuung der Bauelemente-Parameter: Substratstrom der Z-Diode und temperaturabhängiger Widerstands sowie GATE-SOURCE-Spannung des nachgeschalteten Transistors der Halbleiteranordnung. Hohe Genauigkeitsanforderungen an den Temperatur-Schaltpunkt bzw. den Temperatur-Einsatzbeginn können durch Abgleich des temperaturabhängigen Widerstands erfüllt werden. Bei mittleren Genauigkeitsanforderungen kann auch auf einen Abgleich verzichtet werden.

Weiterhin spielen beim erfindungsgemäßen Endstufenbauteil Wannenleckströme keine Rolle. Die Z-Diode kann in allen Betriebszuständen die.Übertemperatur erfassen und einen Sperrstrom führen - unabhängig von der DRAIN-Spannung des Leistungstransistors.

Durch die in den Unteransprüchen aufgeführten Maßnahmen sind vorteilhafte Weiterbildungen und Verbesserungen des im Hauptanspruch angegebenen MOS-Endstufenbauteils möglich.

Um eine Temperatur-Abschaltung zu realisieren, das heißt eine Abschaltung des Endstufenelements bei unzulässig hoher Temperatur, weist die Halbleiteranordnung zweckmäßigerweise wenigstens ein mit dem GATE-Anschluß des Endstufenelements verbundenes Schaltelement auf, durch das bei Überschreiten einer vorgebbaren temperaturabhängigen Steuerspannung die GATE-Spannung auf einen niedrigen Wert, insbesondere auf das Potential des SOURCE-Anschlusses, umschaltbar ist. Hierzu ist das Schaltelement vorzugsweise als Flipflop ausgebildet, das jeweils in geeigneter Weise in seinen Anfangszustand versetzt wird, z.B. durch ein Einschaltsignal des gesamten Endstufenbauteils, so daß sein Ausgang Q beim Auftreten einer Übertemperatur seinen Zustand wechselt und die Endstufe sperrt.

Anstelle einer Temperaturabschaltung kann auch eine Temperaturabregelung treten, das heißt, die GATE-Spannung des Endstufenelements wird mit wachsender Temperatur immer stärker auf das SOURCE-Potential gezogen. Hierzu weist die Halbleiteranordnung wenigstens einen MOS-Transistor auf, dessen DRAIN-SOURCE-Strecke zur Abregelung der GATE-Spannung des Endstufenelements bei Übertemperaturen zwischen dem GATE- und dem SOURCE-Anschluß dieses Endstufenelements geschaltet ist.

Um bei der Temperaturabschaltung oder -abregelung die Schalthysterese zu erhalten, bildet der temperaturabhängige Widerstand in vorteilhafter Weise wenigstens einen Teil einer Widerstandsstrecke, von der ein Abgriff über einen Halbleiterschalter mit dem SOURCE-Anschluß des Endstufenelements verbunden ist, wobei der Halbleiterschalter bei Überschreiten der vorgebbaren Steuerspannung in den Sperrzustand übergeführt wird.

Zur Steuerung des MOS-Transistors oder des Schaltelements in Abhängigkeit der Steuerspannung der Reihenschaltung weist die Halbleiteranordnung zweckmäßigerweise eine mehrstufige Transistoranordnung auf, die zum einen als Verstärker wirkt und zum anderen einen Einfluß auf ein gewünschtes Temperaturverhalten ausüben kann.

Die Anode der Z-Diode stellt die Basis eines parasitären npn-Transistors dar, der in seiner Funktion nicht erwünscht ist. Um daher den Spannungsanstieg an der Anode der Z-Diode zu reduzieren, ist zweckmäßigerweise parallel zu ihr ein Spannungsteiler geschaltet, dessen Abgriffsspannung als Steuerspannung der Halbleiteranordnung zugeführt wird. Die Anodenspannung der Z-Diode kann daher durch den Spannungsteiler auf einen gewünschten Wert reduziert werden.

Eine alternative Lösung des Problems des parasitären Transistors besteht darin, daß der Abgriff der Reihenschaltung mit einem Vergleichsverstärker verbunden ist, dessen Vergleichseingang mit einer Bezugsspannung beaufschlagt ist. Hierbei wird der Spannungsanstieg an der Anode der Z-Diode dadurch begrenzt, daß die Auswertung der Abgriffsspannung über diesen Vergleichsverstärker erfolgt.

Zusätzlich kann in vorteilhafter Weise noch ein Spannungsbegrenzer für die Steuerspannung am Abgriff der Reihenschaltung vorgesehen sein. Hierdurch kann die P-Wanne der Anode der Z-Diode gleichzeitig zur Integration der übrigen Bauelemente für die Übertemperatur-Schutzschaltung benutzt werden. Zur sicheren Funktion ist dabei eine Begrenzung der Abgriffsspannung auf einen Wert von weniger als 300 mV erforderlich. Dies kann durch den Spannungsbegrenzer erreicht werden.

Die Versorgungsspannung für die Reihenschaltung und die Halbleiteranordnung kann eine Referenzspannung oder die äußere GATE-Spannung am vom Endstufenelement abgewandten Anschluß des GATE-Vorwiderstands und/oder die DRAIN-Spannung des Endstufenelements sein. Insbesondere kann die Reihenschaltung von der DRAIN-Spannung und die Halbleiteranordnung von der Referenzspannung oder der äußeren GATE-Spannung beaufschlagt sein. In zweckmäßiger Kombination mit der Übertemperatur-Schutzeinrichtung kann noch ein DRAIN-SOURCE-Spannungsbegrenzer (Klammerung) für das Endstufenelement zum Schutz gegen unzulässig hohe Spannung beim Abschalten von induktiven Lasten vorgesehen sein.

Darüber hinaus kann zusätzlich eine Überlast-Schutzeinrichtung im Endstufenbauelement integriert sein, die eine durch definierte Durchströmung des GATE-Vorwiderstands eine Verschiebung der Übertragungskennlinie des Endstufenelements um einen definierten Spannungs-Offsetwert erzeugende Pegelanpassungsstufe sowie eine den Summenwert der DRAIN-SOURCE-Spannung und der äußeren GATE-SOURCE-Spannung auf einen vorgebbaren Wert begrenzende Begrenzungsstufe aufweisen. Neben dem Schutz gegen unzulässig hohe Abschaltspannungen durch die Klammerung tritt hierdurch noch ein Schutz gegen erhöhte Verlustleistung beispielsweise durch fehlerbehaftete Betriebszustände ein.

Mehrere Chips bzw. Endstufenbauteile können problemlos modulartig parallel betrieben werden, wobei der Chip mit der niedrigsten Klammerspannung die parallelgeschalteten Chips mitansteuert. Ein Abgleich der Klammerspannung auf Grund von Streuungen der Bauelemente-Parameter aus verschiedenen Herstellungs-Chargen ist nicht erforderlich. Die Pegelanpassung wird so abgeglichen, daß Bauelemente aus verschiedenen Herstellungs-Chargen dieselbe Kennlinie (denselben Arbeitspunkt) aufweisen.

ZEICHNUNG

Ausführungsbeispiele der Erfindung sind in der Zeichnung dargestellt und in der nachfolgenden Beschreibung näher erläutert. Es zeigen:

Fig. 1    ein Gesamtschaltbild des monolithisch integrierten MOS-Endstufenbauteils mit einem ersten Ausführungsbeispiel einer Übertemperatur-Schutzeinrichtung zur Abregelung des Ausgangsstroms,

Fig. 2    ein zweites Ausführungsbeispiel einer Übertemperatur-Schutzeinrichtung mit einer Temperaturabschaltung,

Fig. 3    ein drittes Ausführungsbeispiel einer Übertemperatur-Schutzeinrichtung,

Fig. 4    ein viertes Ausführungsbeispiel einer Übertemperatur-Schutzeinrichtung und

Fig. 5    eine alternative Ausgestaltung der in Fig. 1 enthaltenen Überlast-Schutzeinrichtung.

BESCHREIBUNG DER AUSFÜHRUNGSBEISPIELE

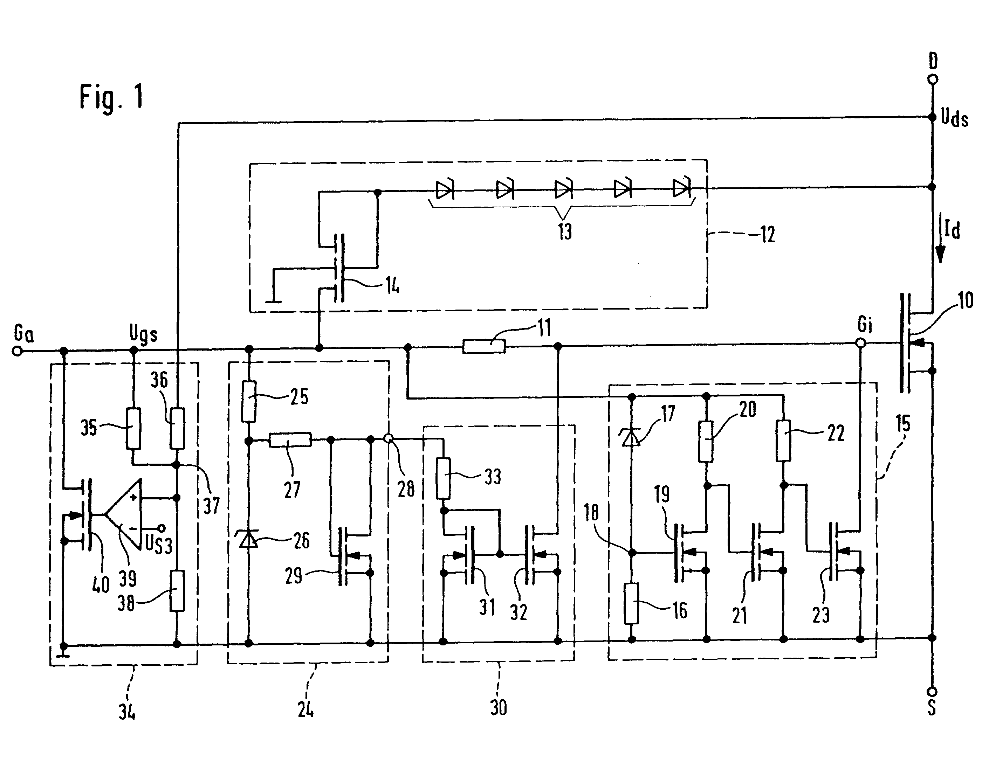

In Fig. 1 ist ein monolithisch integriertes MOS-Endstufenbauteil dargestellt, das beispielsweise als DMOS-Endstufe ausgebildet ist. Es besteht im wesentlichen aus einem als MOS-npn-Transistor ausgebildeten Endstufenelement 10 als steuerbares Halbleiterelement. Dieses Endstufenelement 10 weist in bekannter Weise einen DRAIN-Anschluß D, einen SOURCE-Anschluß S und einen GATE-Anschluß Gi auf. Dem GATE-Anschluß Gi ist ein GATE-Vorwiderstand 11 vorgeschaltet, dessen vom Endstufenelement 10 abgewandter Anschluß den äußeren GATE-Anschluß Ga des gesamten Endstufenbauteils bildet. Zwischen dem DRAIN-Anschluß D und dem äußeren GATE-Anschluß Ga ist ein DRAIN-SOURCE-Spannungsbegrenzer 12 geschaltet, der in üblicher Weise auch als Klammerung bezeichnet wird. Dieser Spannungsbegrenzer 12 besteht im wesentlichen aus der Reihenschaltung einer Vielzahl von Z-Dioden 13 mit einem als Diode geschalteten MOS-Transistor 14, dessen SOURCE-Anschluß mit dem äußeren GATE-Anschluß Ga des gesamten Endstufenbauteils verbunden ist und dessen BULK-Anschluß an Masse bzw. am SOURCE-Anschluß des gesamten Endstufenbauteils liegt. Die Zahl der Z-Dioden 13 hängt von der gewünschten maximal zulässigen Spannung ab. Wird diese Spannung z.B. beim Abschalten von induktiven Lasten überschritten, so wird durch den Stromfluß durch diese Z-Dioden ein weiterer Anstieg der DRAIN-Spannung verhindert.

Eine Übertemperatur-Schutzeinrichtung 15 besteht im wesentlichen aus der Reihenschaltung eines temperaturabhängigen Widerstands 16 mit einer Z-Diode 17, wobei der temperaturabhängige Widerstand 16 einen positiven Temperaturkoeffizienten aufweist. Diese Reihenschaltung ist zwischen den äußeren GATE-Anschluß Ga und den SOURCE-Anschluß S des Endstufenbauteils geschaltet, wobei der Widerstand 16 am SOURCE-Anschluß und die Z-Diode 17 am äußeren GATE-Anschluß Ga liegt. Ein zwischen dem Widerstand 16 und der Z-Diode 17 liegender Abgriff 18 dieses Spannungsteilers ist mit dem GATE-Anschluß eines MOS-Transistors 19 verbunden, dessen DRAIN-SOURCE-Strecke in Reihe mit einem Widerstand 20 zwischen den äußeren GATE-Anschluß Ga und den SOURCE-Anschluß S des Endstufenbauteils geschaltet ist. Dabei liegt der Widerstand 20 am äußeren GATE-Anschluß Ga. Der Verknüpfungspunkt zwischen dem Widerstand 20 und dem MOS-Transistor 19 ist mit dem GATE-Anschluß eines weiteren MOS-Transistors 21 verbunden, der zusammen mit einem Widerstand 22 eine entsprechende Reihenschaltung bildet. Der Abgriff zwischen dem Widerstand 22 und dem MOS-Transistor 21 ist mit dem GATE-Anschluß eines dritten MOS-Transistors 23 verbunden, dessen DRAIN-SOURCE-Strecke zwischen den inneren GATE-Anschluß Gi und den SOURCE-Anschluß S des Endstufenbauteils geschaltet ist.

Die Übertemperatur-Schutzeinrichtung 15 ist im dargestellten Ausführungsbeispiel zur Stromversorgung mit dem äußeren GATE-Anschluß Ga verbunden. Alternativ hierzu kann zur Spannungsversorgung selbstverständlich auch eine Referenzspannungsquelle verwendet werden, die beispielsweise gemäß der Referenzspannungsquelle 24 in Fig. 1 aufgebaut ist.

Die ein temperatursensitives Element bildende Z-Diode 17 weist eine sehr hohe Empfindlichkeit auf. Ihr Sperrstrom verdoppelt sich je 10 K Temperaturerhöhung. Gleichzeitig nimmt bei einer Temperaturerhöhung der Widerstandswert des temperaturabhängigen Widerstands 16 zu, so daß bei einer Temperaturerhöhung der Strom durch diese Reihenschaltung und damit die Spannung am Abgriff 18 steil ansteigt. Auch der MOS-Transistor 19 stellt ein temperaturabhängiges Bauteil dar, das bei einer Temperaturerhöhung schon bei niedrigeren Spannungen anspricht. Hierdurch ergibt sich durch Zusammenwirken dieser Bauteile insgesamt eine hohe Gesamtsteilheit für das Auswertesignal und eine geringe Temperaturunschärfe bei prozeßbedingter Streuung der Bauelemente-Parameter. Der gewünschte Temperaturschaltpunkt bzw. Einsatzbeginn der Temperaturabregelung kann durch Abgleich dieses Widerstands 16 bzw. durch entsprechende Wahl seines Widerstandswerts festgelegt werden. Bei mittleren Genauigkeitsanforderungen kann auf einen exakten Abgleich auch verzichtet werden.

Bei ansteigender Chip-Temperatur steigt somit die Steuerspannung am Abgriff 18 an, was einen vergrößerten Strom durch den MOS-Transistor 19, entsprechend einen verringerten Strom durch den MOS-Transistor 21 und folglich einen erhöhten Strom durch den MOS-Transistor 23 zur Folge hat. Somit wird bei zunehmender Chip-Temperatur die GATE-Spannung am inneren GATE-Anschluß Gi bis zum thermischen Gleichgewicht reduziert, also abgeregelt.

In der Referenzspannungsquelle 24 ist die Reihenschaltung eines Widerstands 25 mit einer Z-Diode 26 zwischen den äußeren GATE-Anschluß Ga und den SOURCE-Anschluß S geschaltet, wobei die Z-Diode 26 am SOURCE-Anschluß S liegt. Der Verknüpfungspunkt zwischen diesen beiden Bauteilen ist über einen Widerstand 27 mit einem Ausgang 28 der Referenzspannungsquelle 24 verbunden. Zwischen dem Ausgang 28 und dem SOURCE-Anschluß des Endstufenelements 10 ist die DRAIN-SOURCE-Strecke eines MOS-Transistors 29 geschaltet, dessen GATE-Anschluß ebenfalls am Ausgang 28 liegt.

Im Betrieb liegt an der Kathode der Z-Diode 26 die Z-Spannung an. Bei einer Spannungserhöhung wird der MOS-Transistor 29 stärker durchgesteuert, so daß die Ausgangsspannung der Referenzspannungsquelle 24 auf einen konstanten Wert geregelt wird.

Eine als Stromspiegel ausgebildete Pegelanpassungsstufe 30 besitzt zwei MOS-Transistoren 31,32 in einer Stromspiegelschaltung, das heißt, die beiden GATE-Anschlüsse sind miteinander verbunden und die beiden SOURCE-Anschlüsse an den SOURCE-Anschluß des Endstufenbauteils angeschlossen. Der DRAIN-Anschluß des MOS-Transistors 31 ist mit den beiden GATE-Anschlüssen sowie über einen Widerstand 33 mit dem Ausgang 28 der Referenzspannungsquelle 24 verbunden. Der DRAIN-Anschluß des MOS-Transistors 32 ist mit dem inneren GATE-Anschluß Gi des Endstufenelements 10 verbunden.

Infolge der festen Referenzspannung am Ausgang 28 fließt durch den linken Zweig der Pegelanpassungsstufe 30, also durch den MOS-Transistor 31, ein konstanter Strom, so daß infolge des Stromspiegels durch den MOS-Transistor 32 ebenfalls ein konstanter Strom fließt. Hierdurch ergibt sich eine definierte Durchströmung des GATE-Vorwiderstands 11, und die dadurch gebildete Pegelanpassung verschiebt die Übertragungskennlinie der Endstufe um einen definierten Spannungs-Offsetwert und hebt die externe Schwellspannung der Endstufe an, das heißt, unterhalb dieses Werts fließt kein Ausgangsstrom zum Endstufenelement 10. Gleichzeitig wird hierdurch eine feste Zuordnung des DRAIN-Stroms Id zur externen GATE-SOURCE-Spannung Ugs am externen GATE-Anschluß Ga erzeugt, die über einen Abgleich festgelegt wird. Die Eingangsspannung Ugs kann nun als Meßgröße für den fließenden Ausgangsstrom Id des Endstufenbauteils benutzt werden. Hierbei wird die Pegelanpassung so gewählt, daß die Steuerkennlinie Id = f (Ugs) einen negativen Temperaturkoeffizienten aufweist und den Ausgangsstrom bei steigender Chip-Temperatur stabilisierend begrenzt. Dies kann z.B. durch geeignete Wahl des Temperaturkoeffizienten der Referenzspannung am Ausgang 28 oder durch geeignete Kombination der Temperaturkoeffizienten der Widerstände 33 und 11 erfolgen.

In einer Begrenzungsstufe 34 sind die Spannungen Ugs am äußeren GATE-Anschluß Ga und die DRAIN-SOURCE-Spannung Uds am DRAIN-Anschluß D des Endstufenelememnts 10 über zwei Widerstände 35,36 an einem Summenpunkt 37 zusammengeführt, der über einen weiteren Widerstand 38 am SOURCE-Anschluß S des Endstufenelements 10 liegt. Die aufsummierten Spannungen am Summenpunkt 37 sind dem nichtinvertierenden Eingang eines vergleichenden Regelverstärkers 39 zugeführt, an dessen Vergleichseingang eine Vergleichsspannung $U_{S3}$ liegt. Der Regelverstärker 39 steuert den GATE-Anschluß eines MOS-Transistors 40, dessen DRAIN-SOURCE-Strecke zwischen den äußeren GATE-Anschluß Ga und den SOURCE-Anschluß S des Endstufenelements 10 geschaltet ist.

Die Verlustleistung des Endstufenelements 10 beträgt Uds . Id. Sie könnte mit einem Analog-Multiplizierer exakt bstimmt werden, jedoch ist dies sehr aufwendig und in integrierter Form kaum darstellbar. Infolge der Pegelanpassungsstufe 30 ist jedoch die Spannung Ugs proportional zum Strom Id. Für die hier gegebenen Randbedingungen (analoger Betrieb) gilt die Näherungslösung für die Verlustleistung P:

$$P = k_1 . Uds + k_2 . Ugs.$$

Diese Addition wird durch die beiden Widerstände 35,36 durchgeführt, so daß am Summenpunkt 37 ein von der Verlustleistung P abhängiger Spannungswert vorliegt. Durch den Regelverstärker 39 soll die Verlustleistung auf den Wert $U_{S3}$ begrenzt werden, das heißt, übersteigt der verlustleistungsabhängige Spannungswert am Summenpunkt 37 den Wert $U_{S3}$, so wird der MOS-Transistor 40 aufgesteuert, was eine Verringerung der Spannung Ugs am äußeren GATE-Anschluß Ga zur Folge hat. Hierdurch erfolgt eine Leistungsbegrenzung und ein Schutz gegen Überlastung des Endstufenelements 10. An den Randbereichen, das heißt bei sehr kleinen Werten Uds bzw. Id, erfolgt wegen der Addition von Uds und Id eine stärkere Begrenzung der Verlustleistung.

Hierdurch können die physikalischen Grenzen des Endstufenbauteils bzw. des Endstufenelements 10 stärker ausgenutzt werden. Durch die Pegelanpassung steht für die sichere Funktion der Leistungsbegrenzung eine ausreichend hohe Versorgungsspannung zur Verfügung, um die Verlustleistung bis auf den Wert Null zu begrenzen. Die Kombination der Leistungsbegrenzung durch die Begrenzungsstufe 34 und die Übertemperatur-Abregelung durch die Übertemperatur-Schutzeinrichtung 15 läßt eine relativ genaue Schwelle für die Leistungsbegrenzung zu, während die Übertemperatur-Abregelung die tatsächliche Verlustleistung so weit reduziert, daß die Chip-Temperatur nicht über eine vorgegebene Grenze ansteigen kann. Der Abgleich der Pegelanpassung auf eine gleiche Steuerkennlinie einerseits und ein negativer Temperaturkoeffizient des Ausgangsstroms Id bei konstanter Eingangsspannung andererseits ermöglichen eine problemlose Parallelschaltung von mehreren Endstufenbauteilen bzw. Chips. Der Chip mit der niedrigsten Klammerspannung steuert die parallelgeschalteten Chips mit an. Ein Abgleich der Klammerspannung wegen Streuungen der Bauelemente-Parameter aus verschiedenen Herstellungs-Chargen ist nicht erforderlich. Die Pegelanpassung durch die Pegelanpassungsstufe 30 erfolgt in der Weise, daß Bauelemente aus verschiedenen Herstellungs-Chargen dieselbe Kennlinie (denselben Arbeitspunkt) aufweisen. Außerdembekommt der Ausgangsstrom Id bei konstanter Eingangsspannung einen negativen Temperaturgang, um Unsymmetrien des Ausgangsstroms verschiedener Chips entgegenzuwirken. Durch Parallelschalten von mehreren Chips kann der maximale Ausgangsstrom Id erhöht werden. Der modulare Aufbau erlaubt durch die verteilte Verlustleistung einen geringen effektiven Wärmewiderstand.

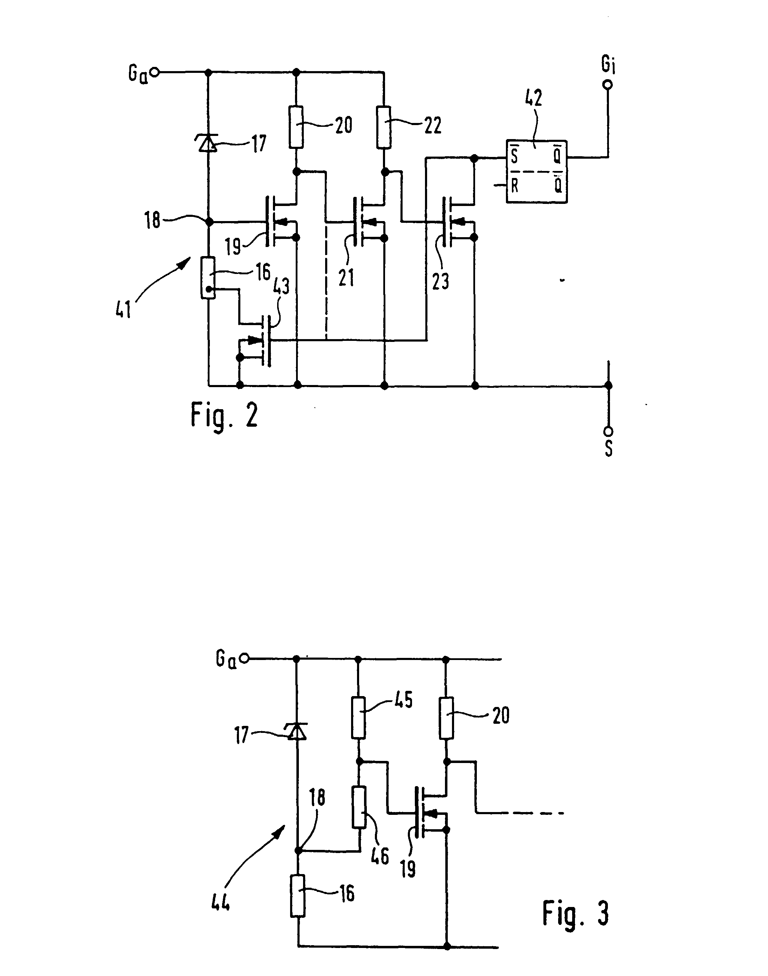

Die in Fig. 2 dargestellte Übertemperatur-Schutzeinrichtung 41 kann anstelle der Übertemperatur-Schutzeinrichtung 15 gemäß Fig. 1 treten. Im Unterschied zur Übertemperatur-Schutzeinrichtung 15 ist nunmehr der DRAIN-Anschluß des MOS-Transistors 23 mit dem Setzeingang S̄ eines Flipflops 42 verbunden, dessen Ausgang Q̄ an den inneren GATE-Anschluß Gi des Endstufenelements 10 angeschlossen ist. Weiterhin ist ein Teilbereich des temperaturabhängigen Widerstands 16 über die DRAIN-SOURCE-Strecke eines MOS-Transistors 43 kurzschließbar, dessen GATE-Anschluß mit dem Setzeingang S̄ des Flipflops 42 verbunden ist.

Diese Übertemperatur-Schutzeinrichtung 41 bewirkt eine Übertemperatur-Abschaltung. Steigt die Spannung am Abgriff 18 über einen bestimmten Wert an, so wird das Flipflop 42 durchgeschaltet und zieht den inneren GATE-Anschluß Gi des Endstufenelements 10 nach Masse bzw. auf das Potential des SOURCE-Anschlusses S. Hierdurch erfolgt eine plötzliche Abschaltung des Endstufenelements 10 ab einer bestimmten Übertemperatur. Das Rücksetzen des Flipflops 42 zur Wiederaufnahme des Betriebs des Endstufenelements 10 kann entweder beim Wiedereinschalten einer Versorgungsspannung erfolgen oder zeitgesteuert nach einer vorgebbaren Zeit oder in Abhängigkeit der Spannung am Abgriff 18, wenn diese einen bestimmten Wert unterschritten hat.

Durch den MOS-Transistor 43 wird eine Schalthysterese realisiert. Bei zunächst gesperrtem MOS-Transistor 23 leitet der MOS-Transistor 43, so daß ein Teil des temperaturabhängigen Widerstands 16 kurzgeschlossen ist. Bei einer bestimmten Chip-Temperatur wird der MOS-Transistor 43 so durchgesteuert, daß das Flipflop 42 schaltet. Durch dasselbe Signal wird der MOS-Transistor 43 gesperrt, so daß nun der gesamte Widerstandswert des temperaturabhängigen Widerstands 16 wirksam wird und die Spannung am Abgriff 18 dadurch sprunghaft ansteigt. Hierdurch wird ein schnelles Wiedereinschalten verhindert und eine Hysterese erreicht. Diese Hysterese ist selbstverständlich auch bei einer Übertemperatur-Abregelung gemäß Fig. 1 einsetzbar, das heißt auch bei nicht vorhandenem Flipflop 42. Die Steuerung des MOS-Transistors 43 kann auch durch die Spannung am GATE-Anschluß des MOS-Transistors 21 erfolgen, wie dies durch eine gestrichelte Linie angedeutet ist.

Das in Fig. 3 dargestellte weitere Ausführungsbeispiel einer Übertemperatur-Schutzeinrichtung 44 kann ebenfalls anstelle der Übertemperatur-Schutzeinrichtung 15 treten. Gleiche oder gleich wirkende Bauteile sind mit denselben Bezugszeichen versehen und nicht nochmals beschrieben. Auf die Darstellung des zweiten und dritten MOS-Transistors 21 und 23 wurde zur Vereinfachung verzichtet. Diese können selbstverständlich ebenfalls vorgesehen sein. In Abwandlung zu den bisherigen Ausführungsbeispielen ist nunmehr ein aus zwei Widerständen 45,46 bestehender Spannungsteiler parallel zur Z-Diode 17 geschaltet, wobei der Abgriff zwischen den Widerständen 45,46 mit dem GATE-Anschluß des MOS-Transistors 19 verbunden ist.

Die Anode der Z-Diode 17 stellt die Basis eines parasitären npn-Transistors dar, der in seiner Funktion nicht erwünscht ist. Dieser Spannungsanstieg wird durch eine geeignete Vorspannung am GATE-Anschluß des MOS-Transistors 19 über den durch die Widerstände 45,46,16 gebildeten Spannungsteiler reduziert, so daß die Ansprechempfindlichkeit der Transistoranordnung erhöht werden kann.

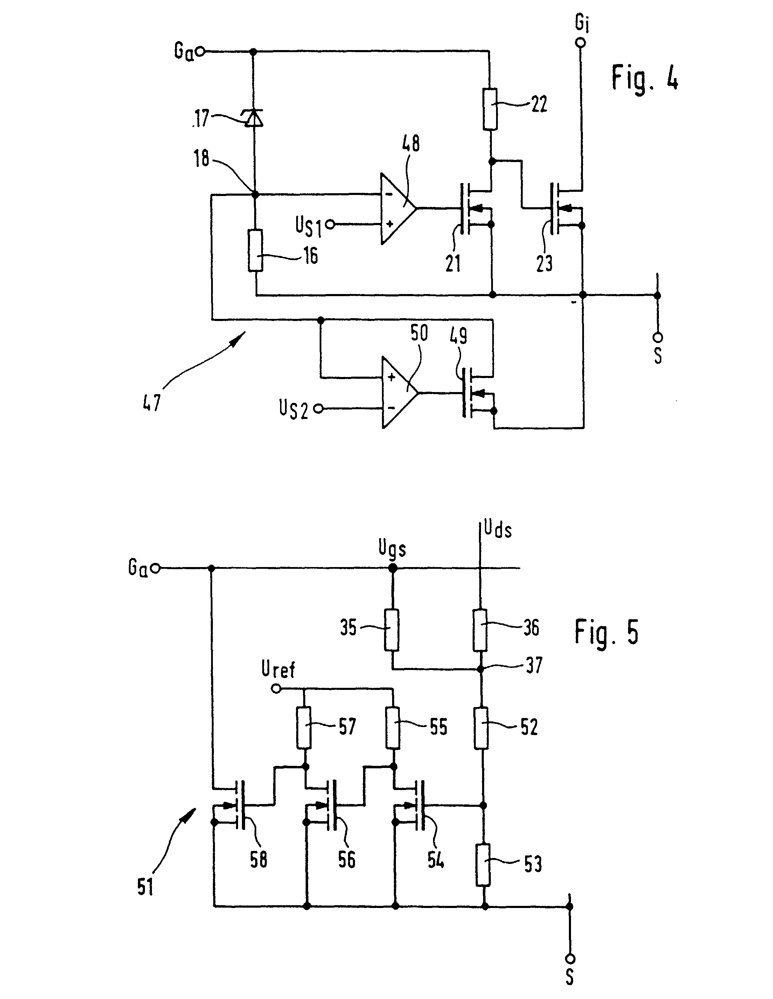

Bei dem in Fig. 4 dargestellten weiteren Ausführungsbeispiel einer Übertemperatur-Schutzeinrichtung 47 sind wiederum gleiche oder gleich wirkende Bauteile mit denselben Bezugszeichen versehen und nicht nochmals beschrieben. Anstelle des MOS-Transistors 19 und des Widerstands 20 tritt nunmehr ein Verstärker 48, dessen invertierender Eingang mit dem Abgriff 18 verbunden ist. Der nichtinvertierende Eingang dieses Verstärkers 48 ist mit einer Vergleichsspannung $U_{S1}$ beaufschlagt. Der Ausgang dieses Verstärkers 48 steuert den MOS-Transistor 21. Weiterhin ist die DRAIN-SOURCE-Strecke eines weiteren MOS-Transistors 49 parallel zum temperaturabhängigen Widerstand 16 geschaltet. Dieser MOS-Transistor 49 wird über einen weiteren Verstärker 50 gesteuert, dessen nicht-invertierender Eingang am Abgriff 18 liegt und dessen invertierender Eingang mit einer Vergleichsspannung $U_{S2}$ beaufschlagt ist.

Der beschriebene Spannungsanstieg an der Anode der Z-Diode 17 wird hier dadurch begrenzt, daß die Auswertung des Signals am Abgriff 18 über den Verstärker 48 erfolgt, wobei die Vergleichsspannung $U_{S1}$ beispielsweise 100-150 mV beträgt. Dies bedeutet, daß der Spannungsanstieg an der Anode auf diesen Wert begrenzt wird. Die P-Wanne der Z-Diode 17 kann gleichzeitig zur Integration der übrigen Bauelemente für die Übertemperatur-Schutzschaltung benutzt werden. Zur sicheren Funktion ist hierzu eine Begrenzung der Spannung am Abgriff 18 auf einen Wert von weniger als 300 mV erforderlich. Diese Begrenzung bewirkt der zweite Verstärker 50, der bei Überschreiten der Vergleichsspannung $U_{S2}$ von beispielsweise 300 mV den hochohmigen Widerstand 16 niederohmig mit dem Masse- bzw. SOURCE-Anschluß verbindet. In einer einfacheren Ausgestaltung kann der Verstärker 50 und der MOS-Transistor 49 auch entfallen.

Bei den in den Fig. 3 und 4 dargestellten Ausführungsbeispielen kann selbstverständlich auch eine Hysterese gemäß Fig. 2 realisiert werden. Ebenfalls ist es möglich, diese Schaltungsvarianten zur Übertemperatur-Abregelung oder zur Übertemperatur-Abschaltung zu verwenden.

In Fig. 5 ist eine Ausführungsvariante einer Begrenzungsstufe 51 dargestellt, die anstelle der Begrenzungsstufe 34 in Fig. 1 treten kann. Gleiche oder gleich wirkende Bauteile sind mit denselben Bezugszeichen versehen und nicht nochmals beschrieben.

Der Summenpunkt 37 ist hier über einen aus zwei Widerständen 52,53 bestehenden Spannungsteiler mit dem SOURCE-Anschluß des Endstufenelements 10 verbunden. Der Abgriff zwischen den Widerständen 52,53 steuert den GATE-Anschluß eines MOS-Transistors 54, der zusammen mit einem Widerstand 55 eine Reihenschaltung bildet, die zwischen eine Referenzspannungsquelle Uref und den SOURCE-Anschluß S geschaltet ist. Der DRAIN-Anschluß dieses MOS-Transistors 54 steuert eine entsprechend geschaltete Reihenschaltung eines MOS-Transistors 56 mit einem Widerstand 57. Der DRAIN-Anschluß des MOS-Transistors 56 ist mit dem GATE-Anschluß eines weiteren MOS-Transistors 58 verbunden, dessen DRAIN-SOURCE-Strecke den äußeren GATE-Anschluß Ga mit dem SOURCE-Anschluß S des Endstufenelements 10 verbindet.

Durch den aus den beiden Widerständen 52,53 bestehenden Spannungsteiler wird das verlustleistungsproportionale Signal am Summenpunkt 37 so heruntergeteilt, daß es zur Ansteuerung der dreistufigen Transistoranordnung geeignet ist. Ab einem bestimmten Spannungswert, also ab einem bestimmten Verlustleistungswert, wird der MOS-Transistor 58 so weit in den stromleitenden Zustand versetzt, daß die Eingangsspannung Ugs und damit der Strom Id abgesenkt wird.

Das beschriebene Endstufenbauteil in seinen verschiedenen dargestellten Varianten kann vollständig monolithisch integriert werden, insbesondere in der DMOS-Technik.

**Patentansprüche**

1.   Monolithisch integriertes MOS-Endstufenbauteil, insbesondere eine DMOS-Endstufe, mit einem einen GATE-, einen SOURCE- und einen DRAIN-Anschluß aufweisenden Endstufenelement und mit einer Übertemperatur-Schutzeinrichtung, wobei ein integrierter GATE-Vorwiderstand (11) vorgesehen ist, wobei die Übertemperatur-Schutzeinrichtung (15; 41; 44; 47) im Endstufenbauteil integriert ist und eine Reihenschaltung einer Diode (17) mit einem Widerstand (16) aufweist, wobei der Widerstand am SOURCE-Anschluß (S) angeschlossen ist, wobei diese als temperaturempfindliches Element dienende Reihenschaltung mit einer Versorgungsspannung beaufschlagt ist, wobei eine von einer Steuerspannung am Abgriff (18) der Reihenschaltung gesteuerte Halbleiteranordnung zur Reduzierung der GATE-Spannung beim Auftreten von Übertemperaturen vorgesehen ist und wobei die Halbleiteranordnung wenigstens ein mit dem GATE-Anschluß (Gi) des Endstufenelements (10) verbundenes Schaltelement aufweist, durch das bei Überschreitung einer vorgebbaren temperaturabhängigen Steuerspannung die GATE-Spannung auf einen niedrigen Wert, insbesondere auf das Potential des SOURCE-Anschlusses (S), umschaltbar ist, dadurch gekennzeichnet, daß die Diode (17) eine Zenerdiode ist, daß die Zenerdiode in Sperrichtung geschaltet ist, daß der Sperrstrom der Zenerdiode mit zunehmender Temperatur zunimmt, daß der Widerstand (16) temperaturabhängig ist und einen positiven Temperaturkoeffizienten aufweist und daß die Zenerdiode unterhalb ihrer Durchbruchspannung betrieben wird.

2. Endstufenbauteil nach Anspruch 1, dadurch gekennzeichnet, daß das Schaltelement (42) als Flipflop ausgebildet ist.

3. Endstufenbauteil nach Anspruch 1, dadurch gekennzeichnet, daß die Halbleiteranordnung wenigstens einen MOS-Transistor (23) aufweist, dessen DRAIN-SOURCE-Strecke zur Abregelung der GATE-Spannung des Endstufenelements (10) bei Übertemperaturen zwischen dem GATE-Anschluß (Gi) und dem SOURCE-Anschluß (S) dieses Endstufenelements (10) geschaltet ist.

4. Endstufenbauteil nach einem der Ansprüche 1 bis 3,
dadurch gekennzeichnet, daß der temperaturabhängige Widerstand (16) wenigstens einen Teil einer Widerstandsstrecke bildet, von der ein Abgriff über einen Halbleiterschalter (43) mit dem SOURCE-Anschluß (S) des Endstufenelements (10) verbunden ist, wobei der Halbleiterschalter (43) zur Erzeugung einer Hysterese bei Überschreitung der vorgebbaren Steuerspannung in den Sperrzustand übergeführt wird.

5. Endstufenbauteil nach einem der Ansprüche 1 bis 4,
dadurch gekennzeichnet, daß zur Steuerung des MOS-Transistors (23) oder des Schaltelements (42) in Abhängigkeit der Steuerspannung der Reihenschaltung die Halbleiteranordnung eine mehrstufige Transistoranordnung aufweist.

6. Endstufenbauteil nach einem der vorhergehenden Ansprüche, dadurch gekennzeichnet, daß parallel zur Z-Diode (17) ein Spannungsteiler (45,46) geschaltet ist, dessen Abgriffsspannung als Steuerspannung der Halbleiteranordnung zugeführt ist.

7. Endstufenbauteil nach einem der Ansprüche 1 bis 5,
dadurch gekennzeichnet, daß der Abgriff (18) der Reihenschaltung mit einem Vergleichsverstärker (48) verbunden ist, dessen Vergleichseingang mit einer Bezugsspannung ($U_{S1}$) beaufschlagt ist.

8. Endstufenbauteil nach Anspruch 7, dadurch gekennzeichnet, daß ein Spannungsbegrenzer (49,50) für die Steuerspannung am Abgriff (18) der Reihenschaltung vorgesehen ist.

9. Endstufenbauteil nach einem der vorhergehenden Ansprüche, dadurch gekennzeichnet, daß die Versorgungsspannung für die Reihenschaltung und die Halbleiteranordnung eine Referenzspannung oder die äußere GATE-Spannung (Ugs) am vom Endstufenelement (10) abgewandten Anschluß des GATE-Vorwiderstandes (11) und/oder die DRAIN-Spannung (Uds) des Endstufenelements (10) ist.

10. Endstufenbauteil nach Anspruch 9, dadurch gekennzeichnet, daß die Reihenschaltung von der DRAIN-Spannung (Uds) und die Halbleiteranordnung von der Referenzspannung oder der äußeren GATE-Spannung (Ugs) beaufschlagt ist.

11. Endstufenbauteil nach einem der vorhergehenden Ansprüche, dadurch gekennzeichnet, daß ein DRAIN-SOURCE-Spannungsbegrenzer (Klammerung) (12) für das Endstufenelement (10) vorgesehen ist.

12. Endstufenbauteil nach einem der vorhergehenden Ansprüche, dadurch gekennzeichnet, daß zusätzlich eine Überlast-Schutzeinrichtung (34) im Endstufenbauteil integriert ist.

13. Endstufenbauteil nach Anspruch 12, dadurch gekennzeichnet, daß die Überlast-Schutzeinrichtung eine durch definierte Durchströmung des GATE-Vorwiderstands (11) eine Verschiebung der Übertragungs-Kennlinie des Endstufenelements (10) um einen definierten Spannungs-Offsetwert erzeugende Pegelanpassungsstufe (30) sowie eine den Summenwert der DRAIN-SOURCE-Spannung (Uds) und der äußeren GATE-SOURCE-Spannung (Ugs) auf einen vorgebbaren Wert ($U_{S3}$) begrenzende Begrenzungsstufe (34;51) aufweist.

14. Endstufenbauteil nach einem der vorhergehenden Ansprüche, gekennzeichnet durch modulartige Parallelschaltung von mehreren Endstufenbauteilen.

**Claims**

1. Monolithically integrated MOS output stage component, in particular a DMOS output stage, with an output stage element having a GATE, a SOURCE and a DRAIN terminal and with an overtemperature protection device, an integrated GATE series resistor (11) being provided, the overtemperature protection device (15; 41; 44; 47) being integrated in the output stage component and having a series circuit formed by a diode (17) and a resistor (16), the resistor being connected to the SOURCE terminal (S), a supply voltage being applied to this series circuit serving as temperature-sensitive element, a semiconductor arrangement, which is controlled by a control voltage at the tap (18) of the series circuit, for reducing the GATE voltage when overtemperatures occur being provided, and the semiconductor arrangement having at least one switching element which is connected to the GATE terminal (Gi) of the output stage element (10) and by means of which, when a predeterminable temperature-dependent control voltage is exceeded, the GATE voltage can be changed over to a low value, in particular to the potential of the SOURCE terminal (S), characterized in that the diode (17) is a zener diode, in that the zener diode is reverse-biased, in that the reverse current of the zener diode increases as the temperature increases, in that the resistor (16) is temperature-dependent and has a positive temperature coefficient, and in that the zener diode is operated below its breakdown voltage.

2. Output stage component according to Claim 1, characterized in that the switching element (42) is designed as a flip-flop.

3. Output stage component according to Claim 1, characterized in that the semiconductor arrangement has at least one MOS transistor (23), whose DRAIN-SOURCE path, for limiting the GATE voltage of the output stage element (10) in the event of overtemperatures, is connected between the GATE terminal (Gi) and the SOURCE terminal (S) of this output stage element (10).

4. Output stage component according to one of Claims 1 to 3, characterized in that the thermistor (16) forms at least part of a resistance path from which a tap is connected via a semiconductor switch (43) to the SOURCE terminal (S) of the output stage element (10), the semiconductor switch (43) being transferred to the off state for the purpose of generating hysteresis when the predeterminable control voltage is exceeded.

5. Output stage component according to one of Claims 1 to 4, characterized in that the semiconductor arrangement has a multi-stage transistor arrangement for the purpose of controlling the MOS transistor (23) or the switching element (42) in dependence on the control voltage of the series circuit.

6. Output stage component according to one of the preceding claims, characterized in that a voltage divider (45, 46) is connected in parallel with the zener diode (17), the tap voltage of which voltage divider is fed as control voltage to the semiconductor arrangement.

7. Output stage component according to one of Claims 1 to 5, characterized in that the tap (18) of the series circuit is connected to a comparison amplifier (48), whose comparison input has a reference-earth voltage ($U_{S1}$) applied to it.

8. Output stage component according to Claim 7, characterized in that provision is made of a voltage limiter (49, 50) for the control voltage at the tap (18) of the series circuit.

9. Output stage component according to one of the preceding claims, characterized in that the supply voltage for the series circuit and the semiconductor arrangement is a reference voltage or the external GATE voltage (Ugs) at that terminal of the GATE series resistor (11) which is remote from the output stage element (10), and/or the DRAIN voltage (Uds) of the output stage element (10).

10. Output stage component according to Claim 9, characterized in that the DRAIN voltage (Uds) is applied to the series circuit and the reference voltage or the external GATE voltage (Ugs) is applied to the semiconductor arrangement.

11. Output stage component according to one of the preceding claims, characterized in that provision is made of a DRAIN-SOURCE voltage limiter (clamping) (12) for the output stage element (10).

12. Output stage component according to one of the preceding claims, characterized in that an overload protection device (34) is additionally integrated in the output stage component.

13. Output stage component according to Claim 12, characterized in that the overload protection device has a level matching stage (30), which produces a shift in the transfer characteristic of the output stage element (10) by a defined voltage offset value as a result of a defined throughflow of the GATE series resistor (11), as well as a limiting stage (34; 51), which limits the summation value of the DRAIN-SOURCE voltage (Uds) and the external GATE-SOURCE voltage (Ugs) to a predeterminable value

($U_{S3}$).

**14.** Output stage component according to one of the preceding claims, characterized by module-like connection in parallel of a plurality of output stage components.

**Revendications**

**1.** Composant d'étage de sortie MOS à intégration monolithique, notamment étage de sortie DMOS avec un élément d'étage de sortie comportant une borne de GRILLE, une borne de SOURCE et une borne de DRAIN, et une installation de protection de surchauffe, avec

- une résistance intermédiaire de GRILLE (11), intégrée,
- l'installation de protection de surchauffe (15, 41, 44, 47) étant intégrée dans le composant d'étage de sortie et présentant un montage en série formé d'une diode (17) et d'une résistance (16),
- la résistance est reliée à la borne de SOURCE (S),
- ce montage en série servant d'élément sensible en température recevant une tension d'alimentation,
- un montage semi-conducteur commandé par une tension de commande à la prise (18) du montage en série réduisant la tension de GRILLE lorsque se produit une surchauffe et,
- le montage semi-conducteur comportant au moins un élément de commutation relié à la borne de GRILLE (Gi) de l'élément d'étage de sortie (10) pour qu'en cas de dépassement d'une tension de commande prédéterminée, dépendant de la température, la tension de GRILLE commute sur une valeur faible, notamment sur le potentiel de la borne de SOURCE (S),

caractérisé en ce que

- la diode (17) est une diode Zener branchée dans le sens bloquant,
- le courant de blocage de la diode Zener augmente avec la température,
- la résistance (16) dépend de la température et présente un coefficient de température positif et,
- la diode Zener fonctionne en dessous de sa température de claquage.

**2.** Composant d'étage de sortie selon la revendication 1,
caractérisé en ce que

l'élément de commutation (42) est un flip-flop.

**3.** Composant d'étage de sortie selon la revendication 1,
caractérisé en ce que
le montage semi-conducteur comporte au moins un transistor MOS (23) dont le chemin DRAIN-SOURCE est branché pour réguler la tension de GRILLE de l'élément d'étage de sortie (10), en cas de surchauffe, entre la borne de GRILLE (Gi) et la borne de SOURCE (S) de cet élément d'étage de sortie (10).

**4.** Composant d'étage de sortie selon l'une des revendications 1 à 3,
caractérisé en ce que
la résistance (16) dépendant de la température forme au moins une partie d'un chemin résistant dont une prise est reliée par un commutateur semi-conducteur (43) à la borne de SOURCE (S) de l'élément d'étage de sortie (10), le commutateur semi-conducteur (43) étant bloqué pour générer une hystérésis au dépassement de la tension de commande prédéterminée.

**5.** Composant d'étage de sortie selon l'une des revendications 1 à 4,
caractérisé en ce que
le montage semi-conducteur comporte un montage à transistors à plusieurs étages pour commander le transistor MOS (23) ou l'élément de commutation (42) en fonction de la tension de commande du montage en série.

**6.** Composant d'étage de sortie selon l'une quelconque des revendications précédentes,
caractérisé par
un diviseur de tension (45, 46) en parallèle sur la diode Z (17), dont la tension de la prise est appliquée comme tension de commande au montage semi-conducteur.

**7.** Composant d'étage de sortie selon l'une des revendications 1 à 5,
caractérisé en ce que
la prise (18) du montage en série est reliée à un amplificateur comparateur (48) dont l'entrée de comparaison reçoit une tension de référence ($U_{S1}$).

**8.** Composant d'étage de sortie selon la revendication 7,
caractérisé par
un limiteur de tension (49, 50) pour la tension de commande sur la prise (18) du montage en série.

**9.** Composant d'étage de sortie selon l'une des revendications précédentes,
caractérisé en ce que

la tension d'alimentation du montage en série et du montage semi-conducteur est une tension de référence ou la tension extérieure de PORTE (Ugs) de la borne de la résistance intermédiaire de GRILLE (11) du côté opposé à celui de l'élément d'étage de sortie (10), et/ou la tension de DRAIN (Uds) de l'élément d'étage de sortie (10).

**10.** Composant d'étage de sortie selon la revendication 9,
caractérisé en ce que
le montage en série reçoit la tension de DRAIN (Uds) et le montage semi-conducteur reçoit la tension de référence ou la tension de GRILLE extérieure (Ugs).

**11.** Composant d'étage de sortie selon l'une quelconque des revendications précédentes,
caractérisé par
un limiteur de tension DRAIN-SOURCE (écrêteur) (12) pour l'élément d'étage de sortie (10).

**12.** Composant d'étage de sortie selon l'une quelconque des revendications,
caractérisé par
une installation de protection de surcharge (34) supplémentaire intégrée dans le composant d'étage de sortie.

**13.** Composant d'étage de sortie selon la revendication 12,
caractérisé en ce que
l'installation de protection de surcharge comprend un étage d'adaptation de niveau (30) qui génère un décalage de la caractéristique de transfert de l'élément d'étage de sortie (10), d'une valeur de décalage de tension définie par le passage d'un courant défini dans la résistance intermédiaire (11) de la GRILLE, ainsi qu'un étage limiteur (34, 51) qui limite la somme de la tension DRAIN-SOURCE (Uds) et de la tension (Ugs) extérieure GRILLE-SOURCE, à une valeur prédéterminée (Us3).

**14.** Composant d'étage de sortie selon l'une des revendications précédentes,
caractérisé par
un montage en parallèle, modulaire, de plusieurs composants d'étage de sortie.

Fig. 1

EP 0 595 018 B1

Fig. 2

Fig. 3

EP 0 595 018 B1

Fig. 4

Fig. 5